# EUROPEAN PATENT APPLICATION

(11) **EP 4 752 511 A1**
(43) Date of publication of application: **03.06.2026**
(21) Application number: 25193940.1
(22) Date of filing: 05.08.2025
(51) Int. Cl.: G01K 1/16, G01K 7/01

(54) **TEMPERATURE SENSING STRUCTURE AND RADIO FREQUENCY CIRCUIT**

(30) Priority: 27.11.2024 TW 113145872
(71) Applicant: RichWave Technology Corp., Taipei City 114 (TW)
(72) Inventor: Yang, Po-Hsiang, 114 Taipei City (TW)
(74) Representative: Straus, Alexander

(57) **Abstract**

Disclosed is a temperature sensing structure (100, 100', 100", 100‴) configured to sense a temperature of an object to be tested (120). The temperature sensing structure (100, 100', 100", 100‴) includes a temperature sensing element (TS) and a thermal conductive component (TC, TC', TC", TC"'). The thermal conductive component (TC, TC', TC", TC"') is coupled between the temperature sensing element (TS) and the object to be tested (120) for thermal conduction, and includes a first metal body (104, 200, 302), a second metal body (106, 202, 304), and a metal-insulator-metal structure (108, 204, 306). The first metal body (104, 200, 302) is coupled to the temperature sensing element (TS), the second metal body (106, 202, 304) is coupled to the object to be tested (102), and the metal-insulator-metal structure (108, 204, 306) is connected between the first metal body (104, 200, 302) and the second metal body (106, 202, 304).

## Description

### Field of the Invention

The disclosure relates to a temperature sensing structure and a radio frequency circuit.

### Background of the Invention

In the technology that a radio frequency (RF) power amplifier (PA) is adjusted by an external controller, a temperature sensor needs to be adopted. In the gallium arsenide (GaAs) process of manufacturing the temperature sensor, comparing to the silicon (Si) material, the GaAs material is smaller in thermal conduction energy, and slower in thermal conduction speed, so disposing the temperature sensor next to the power amplifier merely may result in a time difference in temperature sensing between the power amplifier and the temperature sensor due to the thermal conduction properties of the GaAs material, which may lead to a delay in the external controller receiving the temperature sensing results. In this way, the external controller may be unable to adjust the power amplifier timely.

### Summary of the Invention

This in mind, the present invention aims at providing a temperature sensing structure which may significantly reduce time for thermal energy of an object to be tested to be conducted to a temperature sensing element and increase the overall amount of thermal transfer.

This is achieved by an electronic device and according to independent claims. The dependent claims pertain to corresponding further developments and improvements

### Brief Description of the Drawings

FIG. 1 is a cross-sectional view of a temperature sensing structure according to the first embodiment of the disclosure.
FIG. 2 is a cross-sectional view of a temperature sensing structure according to the second embodiment of the disclosure.
FIG. 3 is a cross-sectional view of a temperature sensing structure according to the third embodiment of the disclosure.
FIG. 4 is a top view of a portion of the temperature sensing structure of FIG. 3.
FIG. 5 is a schematic diagram of a radio frequency circuit according to the fourth embodiment of the disclosure.
FIG. 6 is a schematic diagram of a radio frequency circuit according to the fifth embodiment of the disclosure.

### Detailed Description

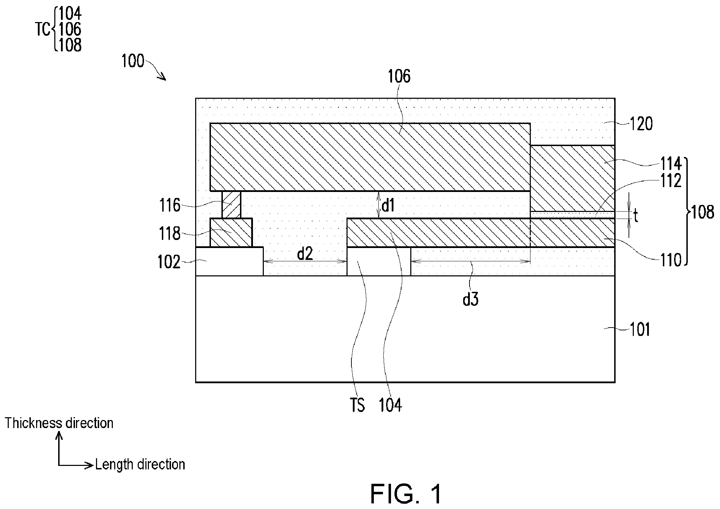

FIG. 1 is a cross-sectional view of a temperature sensing structure according to the first embodiment of the disclosure. In FIG. 1, a temperature sensing structure 100 of the first embodiment is configured to sense a temperature of an object to be tested 102. The temperature sensing structure 100 may generally be formed on a substrate 101, and the object to be tested 102 and the temperature sensing structure 100 may be formed on the same substrate 101.

Please continue to refer to FIG. 1. The temperature sensing structure 100 includes a temperature sensing element TS and a thermal conductive component TC. The temperature sensing element TS may be an element configured to detect temperature, for example, a bipolar junction transistor, a diode, a resistance, or other suitable elements. For instance, if a bipolar junction transistor is adopted as the temperature sensing element TS, the temperature of the object to be tested 102 may be obtained through a voltage change of a base-emitter bias voltage. In another aspect, if a diode is adopted as the temperature sensing element TS, the temperature of the object to be tested 102 may be obtained through a voltage change of a forward bias of the diode. Moreover, if a resistance is adopted as the temperature sensing element TS, the temperature of the object to be tested 102 may be obtained through a change in a resistance value.

The thermal conductive component TC is coupled between the temperature sensing element TS and the object to be tested 102 to for thermal conduction. The thermal conductive component TC includes a first metal body 104, a second metal body 106, and a metal-insulator-metal structure 108. The first metal body 104 is coupled to the temperature sensing element TS, the second metal body 106 is coupled to the object to be tested 102, and the metal-insulator-metal structure 108 is connected between the first metal body 104 and the second metal body 106. In the first embodiment, the metal-insulator-metal structure 108 includes a third metal body 110, an insulator 112, and a fourth metal body 114 stacked along a thickness direction. The insulator 112 is connected between the third metal body 110 and the fourth metal body 114. The third metal body 110 is connected to the first metal body 104, and the fourth metal body 114 is connected to the second metal body 106, so that the temperature of the object to be tested 102 is conducted to the temperature sensing element TS through the thermal conductive component TC including the aforementioned structures. Compared to a temperature sensing device without the metal-insulator-metal structure 108, thermal conduction time of the thermal conductive component TC with the metal-insulator-metal structure 108 may be reduced by approximately 1000 times, and the thermal transfer may be increased by approximately 1000 times.

In FIG. 1, a shortest distance d1 in the thickness direction between the second metal body 106 and the first metal body 104 is greater than a thickness t of the insulator 112. In some embodiments, a ratio (d1/t) of the shortest distance d1 between the second metal body 106 and the first metal body 104 to the thickness t of the insulator 112 may be greater than or equal to 5 and less than or equal to 25. If the aforementioned ratio (d1/t) is less than 5, a path of the thermal conductive component TC is too long, which is unfavorable for thermal conduction. If the aforementioned ratio (d1/t) is greater than 25, a short circuit may occur. FIG. 1 shows that the fourth metal body 114 and the second metal body 106 are two separate structures. The fourth metal body 114 and the second metal body 106 may also be formed together on top of the first metal body 104 and the third metal body 110 through a process, and because the thickness t of the insulator 112 is smaller than the shortest distance d1 between the second metal body 106 and the first metal body 104, the fourth metal body 114 is slightly lower than the second metal body 106 in the thickness direction. Furthermore, to make the thermal conductive component TC conduct the temperature of the object to be tested 102 more effectively, the thermal conductive component TC may further include a conductive via 116 and a fifth metal body 118, where the second metal body 106 is coupled to the object to be tested 102 through the conductive via 116 and the fifth metal body 118. In some embodiments, the fifth metal body 118, the first metal body 104, and the third metal body 110 may be manufactured by using the same process. For example, the fifth metal body 118, the first metal body 104, and the third metal body 110 are all first metal layers (also known as M1) in semiconductor elements, and different circuit portions are defined through a photomask process. In other embodiments, a formation step of the fifth metal body 118 may be different from formation steps of the first metal body 104 and the third metal body 110. Additionally, the figure represents a film layer covering the temperature sensing element TS and the thermal conductive component TC with a single dielectric layer 120, but it should be known that the entire dielectric layer 120 may be composed of several layers of dielectric materials.

In an embodiment, the thickness t of the insulator 112 may be less than 1 µm, for example, less than 0.5 µm, to facilitate thermal conduction. On the other hand, the thickness t of the insulator 112 only needs to be sufficient to electrically block a DC operation of the object to be tested 102. In an embodiment considering an RF application, an equivalent capacitance value of the metal-insulator-metal structure 108 may be greater than or equal to 50 fF and less than or equal to 300 fF. Alternatively, a contact area between the insulator 112 and the third metal body 110 may be greater than or equal to 86 µm² and less than or equal to 530 µm². Compared to the temperature sensing device without the metal-insulator-metal structure 108, the thermal conductive component TC with the metal-insulator-metal structure 108 only changes an operating current of the object to be tested 102 by 0.5%. Moreover, regardless of high-power or low-power signals, the operating power of the object to be tested 102 changes by less than 0.3%, indicating that the metal-insulator-metal structure 108 has a very small impact on the object to be tested 102. In an embodiment not considering the RF application, the equivalent capacitance value of the metal-insulator-metal structure 108 may be increased or decreased according to requirements. Alternatively, a contact area between the insulator 112 and the third metal body 110 may be increased or decreased according to requirements.

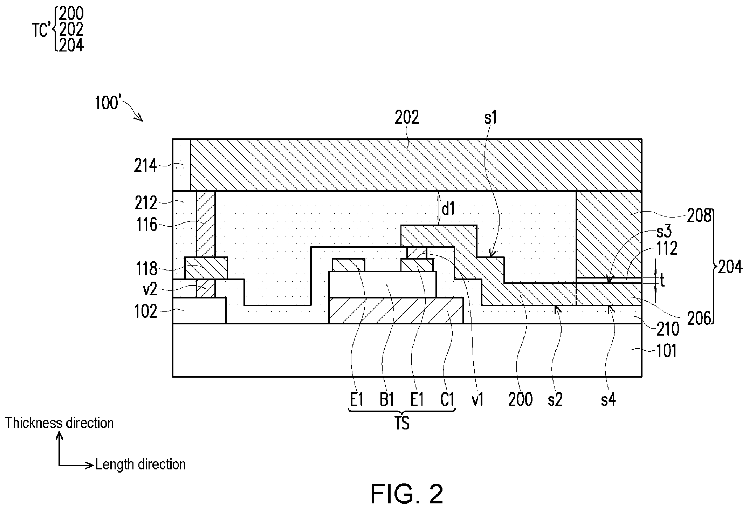

Please refer to FIG. 1 again. The insulator 112 does not overlap with the temperature sensing element TS. In other words, in the cross-sectional view, a shortest distance d3 between the insulator 112 and the temperature sensing element TS in a length direction is at least greater than 0. In some embodiments, a shortest distance d2 between the temperature sensing element TS and the object to be tested 102 in the length direction may be less than the shortest distance d3 between the temperature sensing element TS and the insulator 112 in the length direction, that is, the temperature sensing element TS is disposed at a position closer to the object to be tested 102 in the length direction, and is separated from the metal-insulator-metal structure 108 by a relatively longer distance. The length direction is, for example, parallel to a surface (for example, an upper surface closer to the temperature sensing element TS or the object to be tested 102, or a lower surface farther from the temperature sensing element TS or the object to be tested 102) of the substrate 101, and is perpendicular to the thickness direction. The cross-sectional view is, for example, in a reference plane formed by the thickness direction and the length direction. The temperature sensing element TS being close to the object to be tested 102 may further reduce the element area and increase sensing speed by reducing a distance of thermal conduction. In another aspect, FIG. 1 does not show the detailed structure of the temperature sensing element TS, but the surface of the temperature sensing element TS may not have a flat profile. If the metal-insulator-metal structure 108 is directly disposed on the surface of the temperature sensing element TS, the metal-insulator-metal structure 108 may cause the thinner insulator 112 to break in areas that are less flat or inclined, which is further explained in the paragraphs describing FIG. 2 below. Therefore, in order to form the metal-insulator-metal structure 108 on a flatter surface farther from the temperature sensing element TS, the shortest distance d3 between the metal-insulator-metal structure 108 and the temperature sensing element TS in the length direction in this disclosure is greater than the shortest distance d2 between the temperature sensing element TS and the object to be tested 102 in the length direction, which may further improve reliability of the metal-insulator-metal structure 108.

FIG. 2 is a cross-sectional view of a temperature sensing structure according to the second embodiment of the disclosure, in which the same reference numerals as in FIG. 1 are used to represent the same or similar parts and components, and the related description of the same or similar parts and components may also refer to the description of FIG. 1, which is not repeated here.

In FIG. 2, a temperature sensing structure 100' includes a temperature sensing element TS and a thermal conductive component TC'. In some embodiments, a material of the temperature sensing element TS may include gallium arsenide (GaAs), such as a gallium arsenide bipolar junction transistor, which may include a collector C1, a base B1, and an emitter E1. The emitter E1 is located on the base B1, and the base B1 is located on the collector C1. The thermal conductive component TC' is coupled between the emitter E1 of the temperature sensing element TS and the object to be tested 102 to for thermal conduction. The thermal conductive component TC' includes a first metal body 200, a second metal body 202, and a metal-insulator-metal structure 204. The metal-insulator-metal structure 204 includes a third metal body 206, an insulator 112, and a fourth metal body 208. The first metal body 200 is conformally disposed on the temperature sensing element TS and may be coupled to the emitter E1 through a via v1 formed in the dielectric layer 210. In some embodiments, the fifth metal body 118 may also be coupled to the object to be tested 102 through another via v2 formed in the dielectric layer 210, the conductive via 116 and the fourth metal body 208 may be formed in the dielectric layer 212, and the second metal body 202 may be formed in the dielectric layer 214 top of the dielectric layer 212.

Please continue to refer to FIG. 2. The first metal body 200 includes a first surface s1 and a second surface s2 opposite to each other. The first surface s1 is away from the temperature sensing element TS. The third metal body 206 includes a third surface s3 and a fourth surface s4 opposite to each other. The third surface s3 is connected to the insulator 112. Since a surface profile of the temperature sensing element TS is not a complete plane, the first surface s1 conformally formed on the surface thereof is less flat. In contrast, an area where the third metal body 206 is deposited is flatter, so the flatness of the third surface s3 of the third metal body 206 may be greater than the flatness of the first surface s1, to ensure that the metal-insulator-metal structure 204 is not disconnected, thereby improving the structural stability of the temperature sensing structure 100' of the disclosure. In the second embodiment, the shapes and sizes of the second metal body 202 and the fourth metal body 208 in the temperature sensing structure 100' are different from those in the first embodiment, but still meet a condition that the shortest distance d1 between the second metal body 202 and the first metal body 200 in the thickness direction is greater than the thickness t of the insulator 112. Moreover, the ratio range of the shortest distance d1 to the thickness t (d1/t) and other unspecified positional relationships, such as the shortest distance between the temperature sensing element TS and the object to be tested 102, the shortest distance between the temperature sensing element TS and the insulator 112, the equivalent capacitance value range of the metal-insulator-metal structure 204, or the contact area between the insulator 112 and the third metal body 206, may all adopt the settings of the first embodiment or be adjusted to be larger or smaller according to requirements.

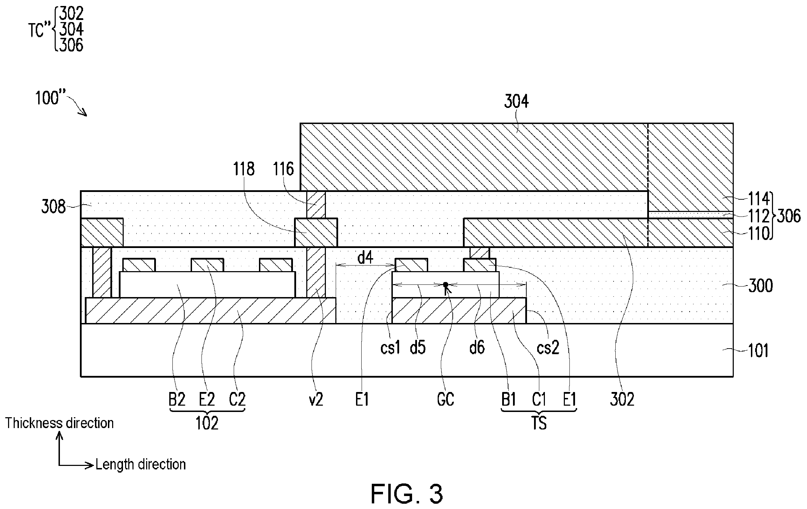

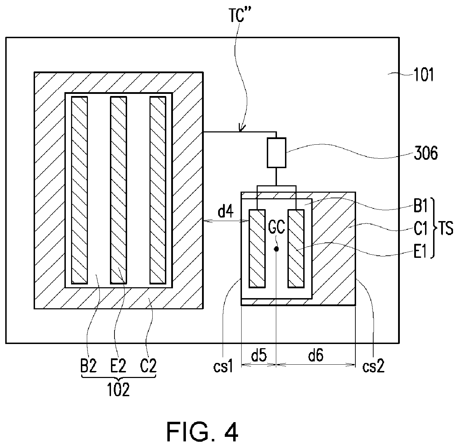

FIG. 3 is a cross-sectional view of a temperature sensing structure according to the third embodiment of the disclosure, where the same reference numerals as in FIG. 1 are used to represent the same or similar parts and components, and the related description of the same or similar parts and components may also refer to the description of FIG. 1, which is not repeated here. FIG. 4 is a top view of a portion of the temperature sensing structure of FIG. 3, and for clarity, some components are omitted.

Please refer to FIG. 3 and FIG. 4. The temperature sensing structure 100" of this embodiment includes a temperature sensing element TS and a thermal conductive component TC". The temperature sensing element TS is a first bipolar junction transistor, and the object to be tested 102 is a second bipolar junction transistor. The temperature sensing element TS at least includes a collector C1, a base B1, and an emitter E1 stacked along the thickness direction. The emitter E1 is disposed on the base B1. The aforementioned collector C1 has a first side surface cs1 close to the object to be tested 102 and a second side surface cs2 away from the object to be tested 102. The object to be tested 102 at least includes a collector C2, a base B2, and an emitter E2. The emitter E2 is located on the base B2, and the base B2 is located on the collector C2. The thermal conductive component TC" is coupled between the emitter E1 of the temperature sensing element TS and the collector C2 of the object to be tested 102. In the length direction perpendicular to the thickness direction, a shortest distance d5 between the first side surface cs1 of the collector C1 and a geometric center GC of the base B1 is less than a shortest distance d6 between the second side surface cs2 of the collector C1 and the geometric center GC of the base B1. In other words, the temperature sensing element TS in the temperature sensing structure 100" of the third embodiment is an asymmetrical bipolar junction transistor. Compared to a general symmetrical bipolar junction transistor, in this third embodiment, a distance d4 between the emitter E1 of the temperature sensing element TS and the collector C2 of the object to be tested 102 (in the length direction) is reduced by using an asymmetrical temperature sensing element TS, thereby shortening the distance of thermal conduction and further reducing an area of the element. The distance d4 between the aforementioned emitter E1 and collector C2 may be, for example, less than 12 µm.

Please continue to refer to FIG. 3. The thermal conductive component TC" may be formed on a dielectric layer 300, and connected to the emitter E1 through the via v1 in the dielectric layer 300, and connected to the collector C2 through the via v2 in the dielectric layer 300. The thermal conductive component TC" at least includes a first metal body 302, a second metal body 304, and a metal-insulator-metal structure 306. The metal-insulator-metal structure 306 is similar to the structure in the aforementioned embodiments, including a third metal body 110, an insulator 112, and a fourth metal body 114. In some embodiments, the first metal body 302 and the third metal body 110 may be formed together on the dielectric layer 300 through the process, while the second metal body 304 may be formed on the dielectric layer 308 covering the first metal body 302 and the third metal body 110. The insulator 112 of the metal-insulator-metal structure 306 may be formed within the dielectric layer 308. The fourth metal body 114 is formed above the insulator 112.

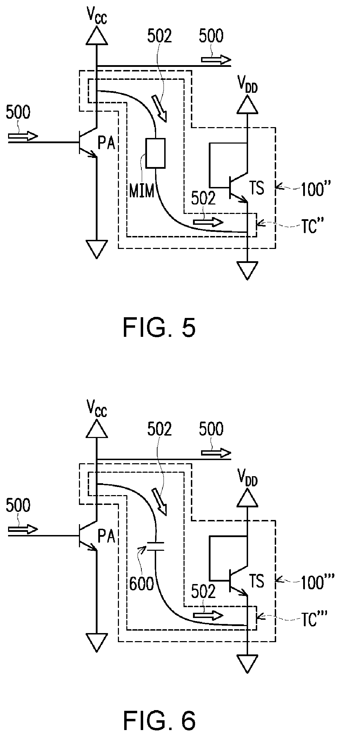

FIG. 5 and FIG. 6 are diagrams of radio frequency circuits according to the fourth embodiment and the fifth embodiment of the disclosure, respectively.

In FIG. 5, the radio frequency circuit includes an amplifier element PA and a temperature sensing structure, which is, for example, the temperature sensing structure 100" in the third embodiment. The temperature sensing structure 100" includes a temperature sensing element and a thermal conductive component. The temperature sensing element TS is, for example, the temperature sensing element TS in the first to third embodiments mentioned above. The temperature sensing element TS may sense a temperature of the amplifier element PA. The temperature sensing element TS is connected to a power supply voltage V_{DD}, and the amplifier element PA is connected to a power supply voltage V_{CC}. The aforementioned thermal conductive component is, for example, the thermal conductive component TC" in the third embodiment, where a metal-insulator-metal structure MIM may prevent a DC signal 500 from coupling to the temperature sensing element TS, but may allow most of a heat flow 502 to reach the temperature sensing element TS through the thermal conductive component TC".

In FIG. 6, the radio frequency circuit includes an amplifier element PA and a temperature sensing structure 100"', the temperature sensing structure 100"' includes a temperature sensing element TS and a thermal conductive component TC"', and the temperature sensing element TS is, for example, the temperature sensing element TS in the first to third embodiments mentioned above. The difference between the thermal conductive component TC‴ in FIG. 6 and the thermal conductive component TC" in FIG. 5 lies in that the metal-insulator-metal structure MIM in FIG. 5 is shown as implemented as a capacitor 600, to prevent the DC signal 500 from coupling to the temperature sensing element TS, but may allow most of the heat flow 502 to reach the temperature sensing element TS through the thermal conductive component TC"'.

## Claims

1. A temperature sensing structure (100, 100', 100", 100"') for sensing a temperature of an object to be tested (102), comprising:
a temperature sensing element (TS); and
a thermal conductive component (TC, TC', TC", TC"'), coupled between the temperature sensing element (TS) and the object to be tested (102) for thermal conduction,
**characterized in that** the thermal conductive component (TC, TC', TC" , TC"') comprises:
a first metal body (104, 200, 302), coupled to the temperature sensing element (TS);
a second metal body (106, 202, 304), coupled to the object to be tested (102); and
a metal-insulator-metal structure (108, 204, 306, MIM, 600), connected between the first metal body (104, 200, 302) and the second metal body (106, 202, 304).

2. The temperature sensing structure (100, 100', 100", 100‴) according to claim 1, **characterized in that** the metal-insulator-metal structure (108, 204, 306) comprises a third metal body (110, 206), an insulator (112), and a fourth metal body (114, 208), and the insulator (112) is connected between the third metal body (110, 206) and the fourth metal body (114, 208).

3. The temperature sensing structure (100, 100', 100", 100‴) according to claim 2, **characterized in that** the third metal body (110, 206) is connected to the first metal body (104, 200, 302), and the fourth metal body (114, 208) is connected to the second metal body (106, 202, 304).

4. The temperature sensing structure (100, 100', 100", 100‴) according to claim 3, **characterized in that** in a reference plane formed by a thickness direction and a length direction, the insulator (112) does not overlap with the temperature sensing element (TS).

5. The temperature sensing structure (100, 100', 100", 100‴) according to claim 3 or 4, **characterized in that** in the thickness direction, a shortest distance (d1) between the second metal body (106, 202, 304) and the first metal body (104, 200, 302) is greater than a thickness (t) of the insulator (112).

6. The temperature sensing structure (100, 100', 100", 100‴) according to claim 5, **characterized in that** a ratio (d1/t) of the shortest distance (d1) between the second metal body (106, 202, 304) and the first metal body (104, 200, 302) to the thickness (t) of the insulator (112) is greater than or equal to 5 and less than or equal to 25.

7. The temperature sensing structure (100, 100', 100", 100"') according to any one of claims 2 to 6, **characterized in that** a thickness (t) of the insulator (112) is less than 1 µm.

8. The temperature sensing structure (100, 100', 100", 100‴) according to any one of claims 2 to 7, **characterized in that** in a length direction, a shortest distance (d2) between the temperature sensing element (TS) and the object to be tested (102) is less than a shortest distance (d3) between the temperature sensing element (TS) and the insulator (112).

9. The temperature sensing structure (100, 100', 100", 100"') according to any one of claims 1 to 8, **characterized in that** the first metal body (200) is conformally disposed on the temperature sensing element (TS).

10. The temperature sensing structure (100, 100', 100", 100‴) according to any one of claims 2 to 9, **characterized in that** the first metal body (200) comprises a first surface (s1) and a second surface (s2) opposite to each other, the first surface (s1) is away from the temperature sensing element (TS), the third metal body (206) comprises a third surface (s3) and a fourth surface (s4) opposite to each other, the third surface (s3) is connected to the insulator (112), and a flatness of the third surface (s3) is greater than a flatness of the first surface (s1).

11. The temperature sensing structure (100, 100', 100", 100"') according to any one of claims 1 to 10, **characterized in that** the temperature sensing element (TS) is a first bipolar junction transistor, the object to be tested (102) is a second bipolar junction transistor, and the thermal conductive component (TC") is coupled between an emitter (E1) of the first bipolar junction transistor and a collector (C2) of the second bipolar junction transistor.

12. The temperature sensing structure (100, 100', 100", 100"') according to any one of claims 1 to 11, **characterized by** comprising a conductive via (116) and a fifth metal body (118), wherein the second metal body (106) is coupled to the object to be tested (102) through the conductive via (116) and the fifth metal body (118).

13. The temperature sensing structure (100, 100', 100", 100"') according to any one of claims 1 to 12, **characterized in that** the temperature sensing element (TS) is a first bipolar junction transistor, the first bipolar junction transistor comprises a collector (C1) and a base (B1) stacked along a thickness direction, the collector (C1) has a first side surface (cs1) close to the object to be tested (102) and a second side surface (cs2) away from the object to be tested (102), and in a length direction perpendicular to the thickness direction, a shortest distance (d5) between the first side surface (cs1) of the collector (C1) and a geometric center (GC) of the base (B1) is less than a shortest distance (d6) between the second side surface (cs2) of the collector (C1) and the geometric center (GC) of the base (B1).

14. The temperature sensing structure (100, 100', 100", 100‴) according to claim 13, **characterized in that** the object to be tested (102) is a second bipolar junction transistor, and in the length direction, a distance (d4) between an emitter (E1) of the first bipolar junction transistor and a collector (C2) of the second bipolar junction transistor is less than 12 µm.

15. A radio frequency circuit (500), comprising:
an amplifier element (PA); and
a temperature sensing structure (100", 100"'), configured to sense a temperature of the amplifier element (PA);
**characterized in that** the temperature sensing structure (100", 100"') comprises:
a temperature sensing element (TS); and
a thermal conductive component (TC", TC"'), coupled between the temperature sensing element (TS) and the amplifier element (PA) for thermal conduction, and comprising:
a first metal body (302), coupled to the temperature sensing element (TS);
a second metal body (304), coupled to the amplifier element (PA); and
a metal-insulator-metal structure (MIM, 600), connected between the first metal body (302) and the second metal body (304).
